(19) Europäisches Patentamt

European Patent Office

Office européen des brevets

(11) **EP 2 393 130 A2**

(12) **EUROPEAN PATENT APPLICATION**

(43) Date of publication:
**07.12.2011 Bulletin 2011/49**

(21) Application number: **10178688.7**

(22) Date of filing: **23.09.2010**

(51) Int Cl.:
*H01L 33/44* (2010.01)  *H01L 33/40* (2010.01)
*H01L 21/268* (2006.01)  *H01L 33/00* (2010.01)
*H01L 33/50* (2010.01)

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**
Designated Extension States:
**BA ME RS**

(30) Priority: **03.06.2010 JP 2010127507**

(71) Applicant: **Kabushiki Kaisha Toshiba
Tokyo (JP)**

(72) Inventors:
• **Akimoto, Yosuke
Tokyo (JP)**
• **Togawa, Ryuichi
Tokyo (JP)**
• **Ito, Hiroshi
Tokyo (JP)**
• **Kojima, Akihiro
Tokyo (JP)**
• **Iduka, Miyuki
Tokyo (JP)**
• **Sugizaki, Yoshiaki
Tokyo (JP)**

(74) Representative: **HOFFMANN EITLE
Patent- und Rechtsanwälte
Arabellastraße 4
81925 München (DE)**

(54) **Light-emitting device and method of manufacturing the same**

(57) According to one embodiment, a light-emitting device (110, 120) includes a semiconductor layer (5), first and second electrode portions (14, 15), a first insulating film (13), and a metal layer (40, 40(A), 40(B)). The semiconductor layer (5) includes a first main surface (5a), a second main surface (5b) on an opposite side to the first main surface (5a), a third main surface (5c) connecting the first and second main surfaces (5a, 5b), and a light-emitting layer (33). The first and second electrode portions (14, 15) are provided on the second main surface (5b) of the semiconductor layer (5). The first insulating film (13) covers the second main surface (5b) of the semiconductor layer (5) and the third main surface (5c) of the semiconductor layer (5). The metal layer (40, 40(A), 40(B)) is stacked on at least the second electrode portion (15) of the first and the second electrode portions (14, 15), and the metal layer (40, 40(A), 40(B)) extends until reaching a part of the first insulating film (13). The part is continuously extended from the first insulating film (13) covering the third main surface (5c).

FIG. 1

EP 2 393 130 A2

Printed by Jouve, 75001 PARIS (FR)

**Description**

Embodiments described herein relate generally to a light-emitting device and a method for manufacturing the same.

BACKGROUND

The applications of light-emitting devices have expanded to lighting apparatuses, back-light sources for image-displaying apparatuses, displaying apparatuses and the like.

In recent years, light-emitting devices smaller in size have been demanded. In a manufacturing method proposed to enhance mass productivity, a semiconductor layer including a light-emitting layer is formed on a substrate by crystal growth, then the substrate is removed from the semiconductor layer by laser-light irradiation, and then the resultant semiconductor layer is divided into multiple devices.

However, further lowering of the contact resistance between the semiconductor layer and the electrode portion provided on the semiconductor layer is demanded.

BRIEF DESCRIPTION OF THE DRAWINGS

FIG. 1 is a schematic cross-sectional view of a light-emitting device according to an embodiment;
FIG. 2 illustrates fluence thresholds for various metal materials;
FIG. 3 is an enlarged cross-sectional view of the relevant part in FIG. 1;
FIG. 4 is a flowchart of a method for manufacturing a light-emitting device according to a second embodiment;
FIG. 5 is a schematic plan view of a method for manufacturing a light-emitting device according to this embodiment in a wafer configuration;
FIGS. 6A to 12 are schematic cross-sectional views of the method for manufacturing a light-emitting device according to a second embodiment; and
FIG. 13 is a schematic cross-sectional view of a light-emitting device according to a third embodiment.

DETAILED DESCRIPTION

In general, according to one embodiment, a light-emitting device includes a semiconductor layer, a first electrode portion and a second electrode portion, a first insulating film, and a metal layer. The semiconductor layer includes a first main surface, a second main surface on an opposite side to the first main surface, a third main surface connecting the first main surface and the second main surface, and a light-emitting layer. The first electrode portion and the second electrode portion are provided on the second main surface of the semiconductor layer. The first insulating film covers the second main surface of the semiconductor layer and the third main surface of the semiconductor layer. The metal layer is stacked on at least the second electrode portion of the first and the second electrode portions, and the metal layer extends until reaching a part of the first insulating film. The part is continuously extended from the first insulating film which covers the third main surface.

Some embodiments will be described below with reference to the drawings.

The drawings are only schematic or conceptual ones. The relationship between the thickness and the width of each portion, the size ratio between of portions, or the like are not necessarily the same as those in the actual ones. In addition, a portion may be shown with different dimensions or different size ratios between the drawings.

In addition, in the description and the drawings, the same element as that described with reference to a preceding drawing are assigned the same reference numerals, and the detailed description thereof is omitted herein.

First Embodiment

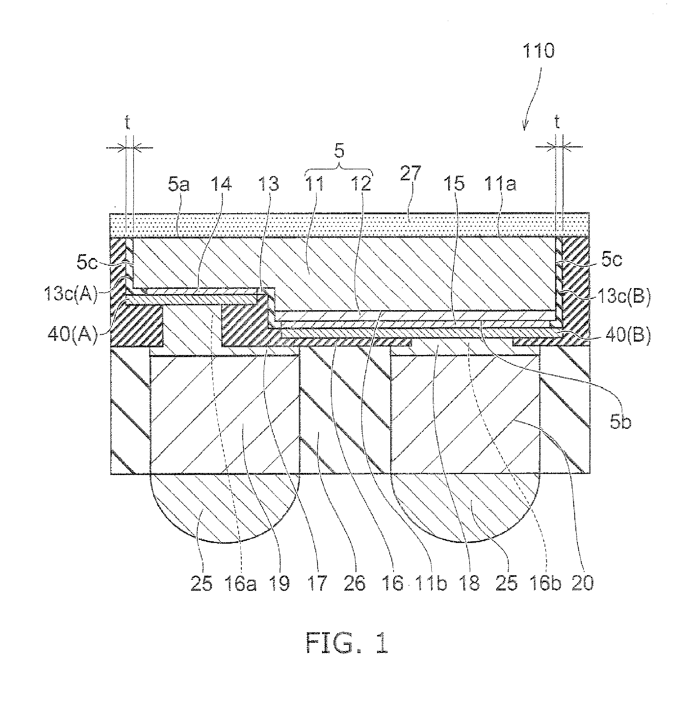

FIG. 1 is a schematic cross-sectional view illustrating a light-emitting device according to a first embodiment.

A light-emitting device 110 according to this embodiment includes: a semiconductor layer 5 that includes a first main surface 5a, a second main surface 5b which is on the opposite side to the first main surface 5a, a third main surface 5c which connects the first main surface 5a and the second main surface 5b, and a light-emitting layer; a first electrode portion 14 and a second electrode portion 15 both of which are provided on the second main surface 5b of the semiconductor layer 5; a first insulating film 13 which covers both the second main surface 5b and the third main surface 5c of the semiconductor layer 5; and a metal layer 40(B) which is stacked at least on the second electrode portion 15 of the first and the second electrode portions 14 and 15 and which extends until reaching the extension of the first insulating film 13(13c) that covers the third main surface 5c close to the metal layer 40(B).

The semiconductor layer 5 includes a light-emitting layer, and is formed by using a substrate as a supporting body. Then, after formation the semiconductor layer, the substrate is removed by irradiation with laser light (laser lift off). The third main surface 5c of the semiconductor layer 5 is a surface which connects the first main surface 5a to the second main surface 5b. There is a case where the third main surface 5c is provided perpendicularly to the first main surface 5a or the second main surface 5b. There is also a case where the third main surface 5c is provided obliquely to the first main surface 5a or the second main surface 5b. Both of these cases are included in this embodiment.

The first insulating film 13c that covers the third main surface 5c transmit the laser light. Accordingly, the thickness t of the first insulating film 13c (thickness along the direction perpendicular to the third main surface 5c) is equal to or larger than the wavelength of the laser light.

The laser light to be used is, for example, light of ArF laser (wavelength: 193 nm), light of KrF laser (wavelength: 248 nm), light of XeCl laser (wavelength: 308 nm), or light of XeF laser (wavelength: 353 nm). The first insulating film 13c is formed to have the thickness t equal to or larger than the wavelength of the laser light used.

In the light-emitting device 110 illustrated in FIG. 1, a metal layer 40(A) is provided to correspond to the fist electrode portion 14 and the metal layer 40(B) is provided to correspond to the second electrode portion 15. Hereinafter, the metal layer 40(A) and the metal layer 40(B) are referred to be a metal layer 40 collectively. The metal layer 40 is provided along the surface of each of the first electrode portion 14 and the second electrode portion 15.

The metal layer 40(A) of the metal layer 40 corresponds to the first electrode portion 14. The metal layer 40(A) is provided to extend to reach the extension, along the third main surface 5c, of the first insulating film 13c (A) covering the third main surface 5c close to the metal layer 40(A).

The metal layer 40(B) of the metal layer 40 corresponds to the second electrode portion 15. The metal layer 40(B) is provided to extend to reach the extension, along the third main surface 5c, of the first insulating film 13c(B) covering the third main surface 5c close to the metal layer 40(B),

A part of the first insulating film 13c(A) and 13c (B) is continuously extended from the first insulating film 13c(A) and 13c(B), which cover the third main surface 5c.

According to the light-emitting device 110 like this, the laser light irradiated at the laser lift off passes through the first insulating film 13c that covers the third main surface 5c, and thus the metal layer 40 is irradiated with the laser light. The metal layer 40 irradiated with the laser light is heated by energy of the laser light. The first electrode portion 14 and the second electrode portion 15 are heated by heating the metal layer 40. Furthermore, portions of the semiconductor layer 5 that are in contact with the first electrode portion 14 and the second electrode portion 15 are heated. The heating reduces the bulk resistance of the semiconductor layer 5, and the contact resistance between the semiconductor layer 5 and each of the first electrode portion 14 and the second electrode portion 15.

The metal layer 40 is made of a material that is melted by the irradiation with the laser light that has passed through the first insulating film 13c. In other word, the material to be used has a lower fluence threshold for melting than the fluence of the laser light to be irradiated. Note that the fluence is the energy amount per unit area of the laser light.

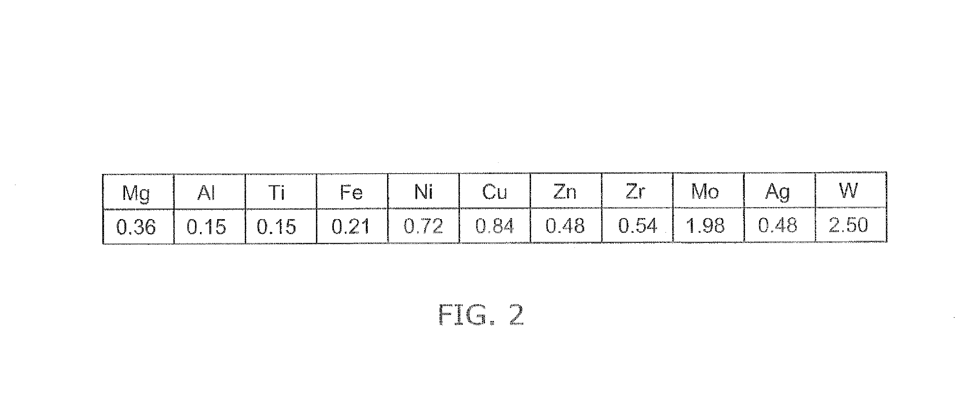

For example, Ikeda et al., "Excimer Laser Ablation Process of Different Metals," Report for 41st Meeting of Nagoya Laser Technopole, 23 of February, 2001, provides the fluence thresholds for various metal materials, which are shown in FIG. 2. Each figure listed in FIG. 2 is the fluence thresholds ($J/cm^2$) for melting the surface of the metal by irradiation with KrF laser light.

Therefore, if, for example, laser light with a fluence of 1.0 $J/cm^2$ is used, the metal to be used contains one of the metals with a fluence threshold not higher than the 1.0 $J/cm^2$ (e.g., Mg, Al, Ti, Fe, Ni, Cu, Zn, Zr, and Ag). Of these metals, for example, Al and Ti are preferable in view of the manufacturing.

The metal layer 40 is in contact with the surface of each of the first electrode portion 14 and the second electrode portion 15. For example, the metal layer 40 is in direct contact with the surface of each of the first electrode portion 14 and the second electrode portion 15. Alternatively, the metal layer 40 may be in contact with the surfaces of the first electrode portion 14 and the second electrode portion 15 via an intermediate layer (not illustrated). All that is necessary is that the heat is conducted from the metal layer 40 to the first electrode portion 14 and the second electrode portion 15.

Further, the metal layer 40 is in contact with the first insulating film 13c at the extended portion. In other word, in the metal layer 40(A) provided corresponding to the first electrode portion 14, the extended portion is in contact with the first insulating film 13c(A) covering the third main surface 5c on the first electrode portion 14 side.

Moreover, in the metal layer 40(B) provided corresponding to the second electrode portion 15, the extended portion is in contact with the first insulating film 13c(B) covering the third main surface 5c on the first electrode portion 15 side.

Note that the metal layer 40 may be in contact with the first insulating film 13c via an intermediate layer (not illustrated). All that is necessary is that the metal layer 40 is irradiated with the laser light that has passed through the first insulating film 13c.

The light-emitting device 110 according to this embodiment is formed collectively in a wafer configuration. The semiconductor layer 5 includes a first semiconductor layer 11 and a second semiconductor layer 12. The first semiconductor layer 11 is, for example, an n-type GaN layer, and serves as a lateral pathway for a current. Note that a conductivity type of the first semiconductor layer is not necessarily the n-type, but may be p-type as well.

The light-emitting device 110 emits the light mainly from a first main surface 11a of the first semiconductor layer 11 (the first main surface 5c of the semiconductor layer 5). The second semiconductor layer 12 is provided on a second main surface 11b of the first semiconductor layer 11. The second main surface 11b is located on the opposite side to the first main surface 11a.

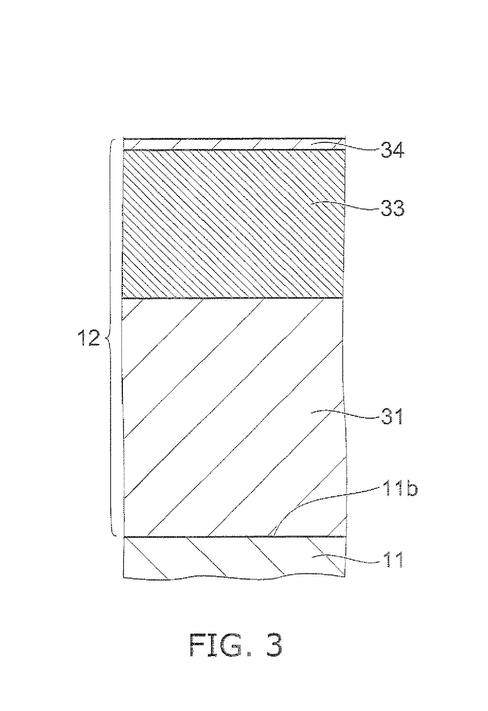

The second semiconductor layer 12 has a stacked structure of multiple semiconductor layers including a light-emitting layer (active layer). An example of the structure is shown in FIG. 3. Note that FIG. 3 shows an upside down image of FIG. 1.

An n-type GaN layer 31 is provided on the second main surface 11b of the first semiconductor layer 11. A light-emitting layer 33 is provided on the GaN layer 31. The light-emitting layer 33 has a multiple quantum well structure containing InGaN, for example. A p-type GaN layer 34 is provided on the light-emitting layer 33.

As shown in FIG. 1, a projected portion and a recessed portion are provided at the second main surface 11b side of the first semiconductor layer 11. The second semiconductor layer 12 is provided on the surface of the projected portion. Accordingly, the projected portion has a stacked structure including the first semiconductor layer 11 and the second semiconductor layer 12.

The bottom surface of the recessed portion is the second main surface 11b of the first semiconductor layer 11. An n-side electrode is provided as the first electrode portion 14 on the second main surface 11b of the recessed portion.

A p-side electrode is provided as the second electrode portion 15 on the surface of the second semiconductor layer 12 opposite to the surface in contact with the first semiconductor layer 11.

The second main surface 11b of the first semiconductor layer 11 is covered with the first insulating film 13 made, for example, of silicon oxide. The first insulating film 13 is made of a material with larger band-gap energy than the energy of the laser light irradiated to remove the substrate after the semiconductor layer 5 is formed on the substrate. The first electrode portion 14 and the second electrode portion 15 are exposed from the first insulating film 13. The first electrode portion 14 and the second electrode portion 15 are insulated from each other by the first insulating film 13, and thus form electrodes electrically independent of each other. The first insulating film 13 also covers the side surfaces of the projected portion including the second semiconductor layer 12.

The metal layer 40 is provided so as to cover each of the first electrode portion 14 and the second electrode portion 15. A second insulating film 16 is provided on the second main surface 11b side so as to cover the first insulating film 13, a part of the metal layer 40(A), and a part of the metal layer 40(B).

The second insulating film 16 and the semiconductor layer 5 are made of materials each with smaller band-gap energy than the energy of the laser light irradiated to remove the substrate after the semiconductor layer 5 is provided on the substrate.

Alternatively, the second insulating film 16 and the semiconductor layer 5 are made of materials that absorb the laser light.

The second insulating film 16 is made, for example, of silicon oxide, silicon nitride, or a resin such as polyimide.

The surface of the second insulating film 16 on the opposite side to the first semiconductor layer 11 and the second semiconductor layer 12 is flattened, and an n-side interconnection as a first interconnection 17 and a p-side interconnection as a second interconnection 18 are provided on the flattened surface.

The first interconnection 17 is also provided in an opening 16a that is formed in the second insulating film 16 until reaching the metal layer 40(A). The first interconnection 17 is electrically connected to the metal layer 40(A) and the first electrode portion 14. Note that an intermediate film (not illustrated) may be provided between the first interconnection 17 and the metal layer 40 (A). The second interconnection 18 is also provided in an opening 16b that is formed in the second insulating film 16 until reaching the metal layer 40(B). The second interconnection 18 is electrically connected to the metal layer 40(B) and the second electrode portion 15. Note that an intermediate film (not illustrated) may be provided between the second interconnection 18 and the metal layer 40(B).

All of the first electrode portion 14, the second electrode portion 15, the first interconnection 17, and the second interconnection 18 are provided at the second main surface 11b side of the first semiconductor layer 11, and form an interconnect layer for supplying an electric current to the light-emitting layer.

An n-side metal pillar is provided on a surface of the first interconnection 17 opposite to the first electrode portion 14 as a first metal pillar 19. A p-side metal pillar is provided on a surface of the second interconnection 18 opposite to the second electrode portion 15 as a second metal pillar 20. The surrounding area of the first metal pillar 19, the surrounding area of the second metal pillar 20, the first interconnection 17, and the second interconnection 18 are covered with a resin (third insulating film) 26.

The first semiconductor layer 11 is electrically connected to the first metal pillar 19 via the first electrode portion 14 and the first interconnection 17. The second semiconductor layer 12 is electrically connected to the second metal pillar 20 via the second electrode portion 15 and the second interconnection 18. External terminals 25 such as, for example, solder balls or metal bumps are provided on the lower-end surfaces of the first metal pillar 19 and the second metal pillar 20 exposed from the resin 26, and the light-emitting device 110 is electrically connected to the external circuit through the external terminals 25.

The thickness of the first metal pillar 19 (the thickness in the vertical direction of FIG. 1) is larger than the thickness of the stacked body including the semiconductor layer 5, the first electrode portion 14, the second electrode portion 15, the first insulating film 13, the second insulating film 16, the first interconnection 17, and the second interconnection 18. Likewise, the thickness of the second metal pillar 20 is also larger than the thickness of the stacked body. If these conditions are satisfied, the aspect ratio (the ratio of the thickness to the planar size) of each of the metal pillars 19 and 20 does not have to be equal to or larger than 1, but may be smaller than 1. Specifically, each of the metal pillars 19 and 20 may have a thickness smaller than its planar size.

According to the structure of this embodiment, even if the semiconductor layer 5 is thin, a mechanical strength can be secured by making the first metal pillar 19, the second metal pillar 20, and the resin 26 thicker. In addition, when the light-emitting device 110 is mounted on a circuit board or the like, the stress applied to the semiconductor layer 5 through the external terminals 25 can be absorbed by the first metal pillar 19 and the second metal pillar 20. Accordingly, the stress applied to the semiconductor layer 5 can be reduced. The resin 26 to reinforce the first metal pillar 19 and the second metal pillar 20 is preferably made of a resin whose coefficient of thermal expansion is equal to, or close to, that of the circuit board or the like. For example, an epoxy resin, a silicone resin, or a fluorine resin is used as the resin 26. In addition, the resin 26 is colored in back, for example. The resin 26 thus prevents the internal light from leaking out and prevents unnecessary external light from entering.

Each of the first interconnection 17, the second interconnection 18, the first metal pillar 19, and the second metal pillar 20 is made, for example, of copper, gold, nickel, or silver. Of these materials, copper is preferable because of its favorable thermal conductivity, its high electromigration resistance, and its excellent adherence to the insulating films.

A phosphor layer 27 is provided on the light-emitting surface of the light-emitting device 110 when necessary. For example, if the light-emitting layer emits blue light and the blue light is emitted from the light-emitting device 110 as it is, no such phosphor layer 27 is necessary. In contrast, if the light-emitting device 110 emits white light or the like, that is, light of a wavelength different from that of the light emitted by the light-emitting layer, the phosphor layer 27 is provided which contains phosphors absorbing the wavelength of the light emitted by the light-emitting layer and thus converting the wavelength of the light emitted by the light-emitting layer into the wavelength of the light to be emitted from the light-emitting device 110.

The light-emitting surface of the light-emitting device 110 may be provided with a lens (not illustrated) when necessary. Lenses of various shapes, such as convex lenses, concave lenses, or aspheric lenses, may be used. How many lenses to provide and where to provide the lenses may be determined appropriately.

In the fight-emitting device 110 according to this embodiment, the metal layer 40 is heated by the laser light irradiated at the laser lift off, so that the bulk resistance of the semiconductor layer 5 as well as the contact resistance between the semiconductor layer 5 and each of the first and the second electrode portions 14 and 15 can be reduced. Consequently, the efficiency of the light-emitting device 110 can be enhanced.

Second Embodiment

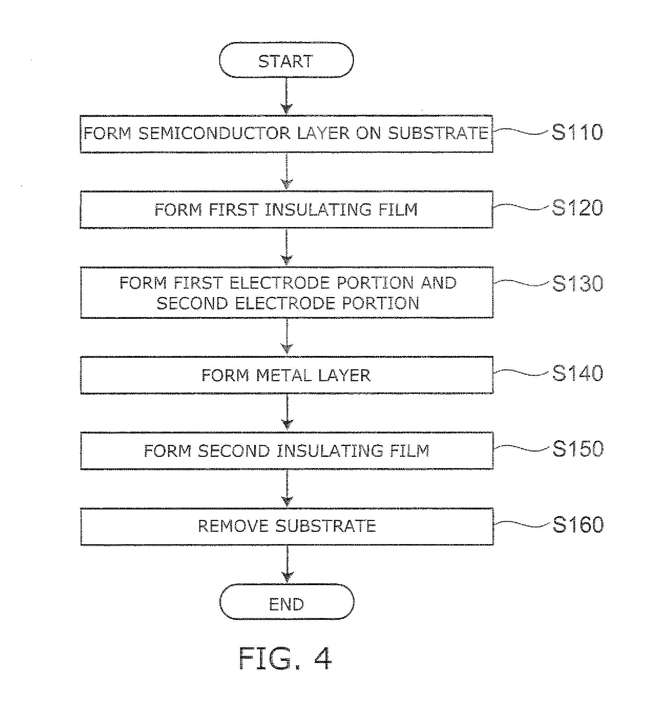

FIG. 4 is a flowchart describing a method for manufacturing a light-emitting device according to a second embodiment.

As shown in FIG. 4, the method for manufacturing a light-emitting device according to this embodiment includes a process of forming a semiconductor layer on a substrate (step S110), a process of forming a first insulating film (step S120), a process of forming a first electrode and a second electrode (step S130), a process of forming a metal layer (step S140), a process of forming a second insulating film (step S150), and a process of removing the substrate (step S160).

In step S110, a semiconductor layer 5 including a light-emitting layer (active layer) is formed on a first main surface of a substrate.

In step S120, a first insulating film 13 is formed to cover at least the top surface (second main surface 5b) of and the side surface (third main surface 5c) of the semiconductor layer 5 that has been formed on the substrate.

In step S130, a first electrode portion 14 and a second electrode portion 15 are formed so as to be electrically continuous to the semiconductor layer 5.

In step S140, a metal layer 40 is formed at least on the second electrode portion 15 of the first and the second electrode portions 14 and 15, and the metal layer 40 extends to reach the extensions of the first insulating film 13c that cover the side surface (third main surface 5c) close to the metal layer.

In step S150, a second insulating film 16 is formed to cover the first insulating film 13.

In step S160, a second main surface of the substrate, which is on the opposite side to the first main surface, is irradiated with laser light, and the substrate is removed from the semiconductor layer 5.

In this embodiment, the band-gap energy of the first insulating film 13 is larger than the energy of the laser light. In the manufacturing method like this, the laser light irradiated at the laser lift off to remove the substrate from the semiconductor layer 5 heats the metal layer 40 so as to reduce the bulk resistance of the semiconductor layer 5 as well as the contact resistance between the semiconductor layer 5 and each of the first and the second electrode portions 14 and 15.

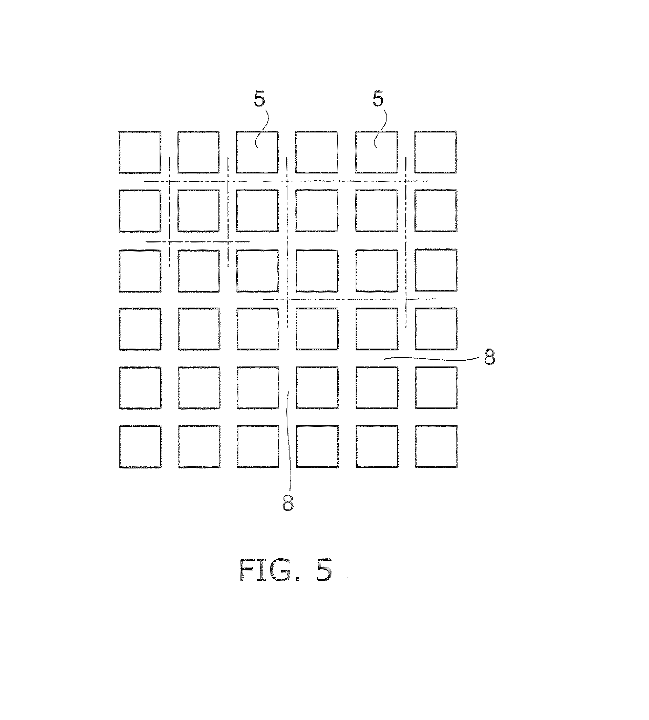

Subsequently, a specific method for manufacturing a light-emitting device will be described with reference to FIGS. 5 to 12.

FIG. 5 is a schematic plan view illustrating a method for manufacturing a light-emitting device according to this embodiment in a wafer configuration.

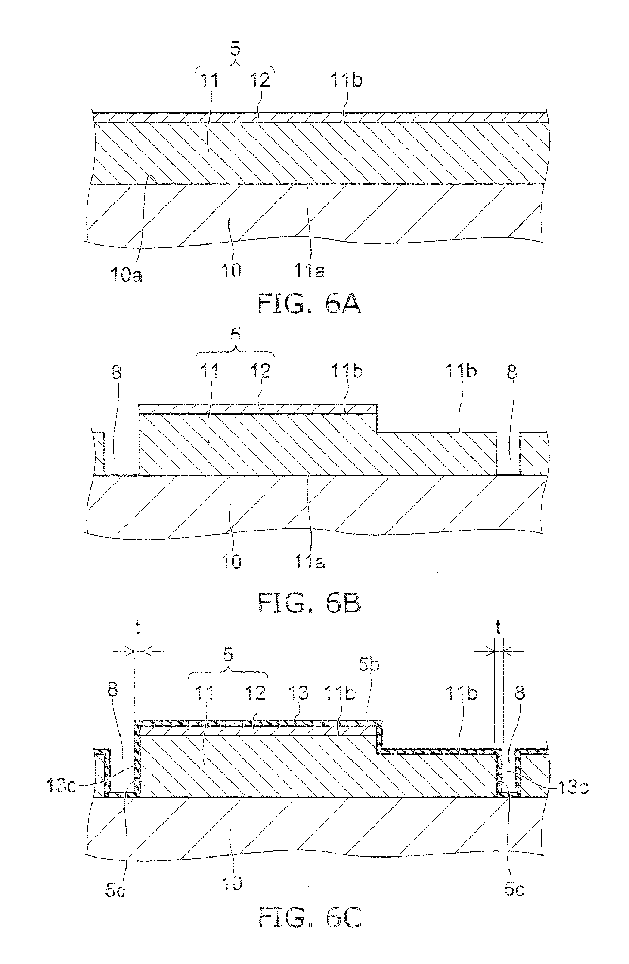

FIGS. 6A to 12 are schematic cross-sectional views describing sequentially the method of manufacturing a light-emitting device.

Firstly, as shown in FIG. 6A, a first semiconductor layer 11 is formed on a first main surface 10a of a substrate 10. The surface on the substrate 10 side of the first semiconductor layer 11 is a first main surface 11a. Next, a second semiconductor layer 12 is formed on the second main surface 11b. If the light-emitting layer is made of a nitride semiconductor, the stacked body of the first semiconductor layer 11 and the second semiconductor layer 12 (semiconductor layer 5) can be formed by crystal growth on a sapphire substrate. As an example, gallium nitride (GaN) is used as the materials for both the first semiconductor layer 11 and second semiconductor layer 12.

Subsequently, a part of the second semiconductor layer 12 and a part of the first semiconductor layer 11 are selectively removed by, for example, reactive ion etching (RIE) method using resist (not illustrated). Consequently, as shown in FIG. 6B, a recessed portion and a projected portion are formed on the second main surface 11b side of the first semiconductor layer 11. The recessed portion corresponds to the portion where a part of the second semiconductor layer 12 and a part of the first semiconductor layer 11 are removed, whereas the projected portion corresponds to the portion where the second semiconductor layer 12 including the light-emitting layer remains after the selective removal process. The second main surface 11b of the first semiconductor layer 11 is exposed from a bottom portion of the recessed portion.

A groove 8 is formed so as to pierce the semiconductor layer 5 and reach the substrate 10. The groove 8 sub-divides the semiconductor layer 5 into multiple sections on the substrate 10. For example, as shown in FIG. 5, the groove 8 is formed in a lattice shape within a wafer plane. Consequently, each of the individual sections of the semiconductor layer 5 is surrounded by the groove 8.

Subsequently, as shown in FIG. 6C, the second main surface 11b of the first semiconductor layer 11, the entire surface of the second semiconductor layer 12, and the inner surface of the groove 8 is covered with a first insulating film 13. The first insulating film 13 is formed by, for example, the chemical vapor deposition (CVD) method. The first insulating film 13 is made, for example, of silicon oxide ($SiO_2$). Thus, The first insulating film 13 covers at least a top surface (second main surface 5b) and side surface (third main surface 5c) of the semiconductor layer 5.

In this embodiment, when the first insulating film 13 is formed, the thickness t (the thickness measured in the direction perpendicular to the third main surface 5c) of the first insulating film 13c covering the side surface (third main surface 5c) of the semiconductor layer 5 is equal to or larger than the wavelength of the laser light to be used to remove the substrate 10.

The laser light to be used is, for example, light of ArF laser (wavelength: 193 nm), light of KrF laser (wavelength: 248 nm), light of XeCl laser (wavelength: 308 nm), or light of XeF laser (wavelength: 353 nm). The first insulating film 13 is formed to have the thickness t equal to or larger than the wavelength of the laser light described above.

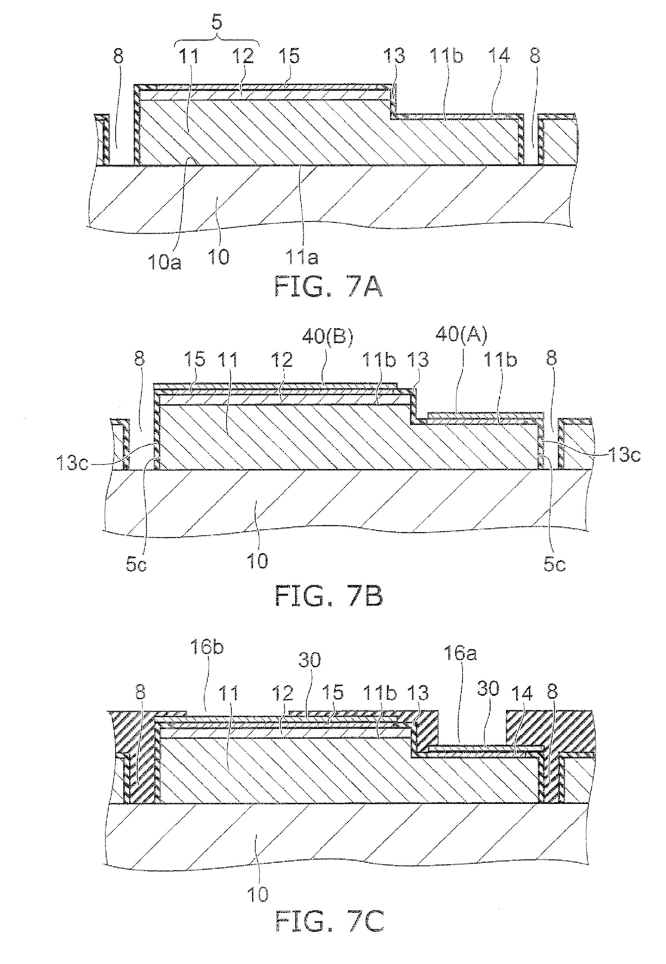

Subsequently, openings are selectively formed in the first insulating film 13. As shown in FIG. 7A, a p-side electrode (second electrode) 15 is formed on the second semiconductor layer 12 of the projected portion, and an n-side electrode (first electrode) 14 is formed on the second main surface 11b of the first semiconductor layer 11 of the recessed portion.

In addition, along with the formation of the openings in the first insulating film 13, the first insulating film 13 formed in the bottom portion of the groove 8 is removed. The first insulating film 13 is selectively removed by etching with a hydrofluoric acid solution. The first insulating film 13 in the bottom portion of the groove 8 is removed until the fist main surface 10a of the substrate 10 is exposed.

Subsequently, as shown in FIG. 7B, a metal layer 40(A) is formed on the first electrode portion 14. In addition, a metal layer 40(B) is formed on the second electrode portion 15. Specifically, the metal layer 40 is firstly formed on the entire surface, and then the metal layer 40 is etched so as to leave the portions that correspond to the first electrode portion 14 and the second electrode portion 15, respectively. The metal layer 40(A) is stacked on the first electrode portion 14, and formed to extend until reaching the extension, along the side surface 5c, of the first insulating film 13c(A) covering the side surface 5c close to the metal layer 40(A). In addition, the metal layer 40(B) is formed along the surface of the second electrode portion 15, and formed to extend until reaching the extension, along the side surface 5c, of the first insulating film 13c(B) covering the side surface 5c close to the metal layer 40(B).

Subsequently, as shown in FIG. 7C, a second insulating film 16 is formed to cover a part of the metal layer 40(A) and a part of the metal layer 40(B), and the first insulating film 13. In addition, the second insulating film 16 is buried into the groove 8. The second insulating film 16 is made, for example, of polyimide.

After the formation of the second insulating film 16, both an opening 16a that reaches the first electrode portion 14 and an opening 16b that reaches the second electrode portion 15 are formed in the second insulating film 16 as shown in FIG. 7C with, for example, a solution of hydrofluoric acid.

Subsequently, seed metal (not illustrated) is formed on the top surface of the second insulating film 16 as well as on the inner wall (the side and bottom surface) of each of the opening 16a and the opening 16b, then resist for plating (not illustrated) is formed, and, after that, a Cu plating process is performed with the seed metal used as the current pathway. The seed meal contains Cu, for example.

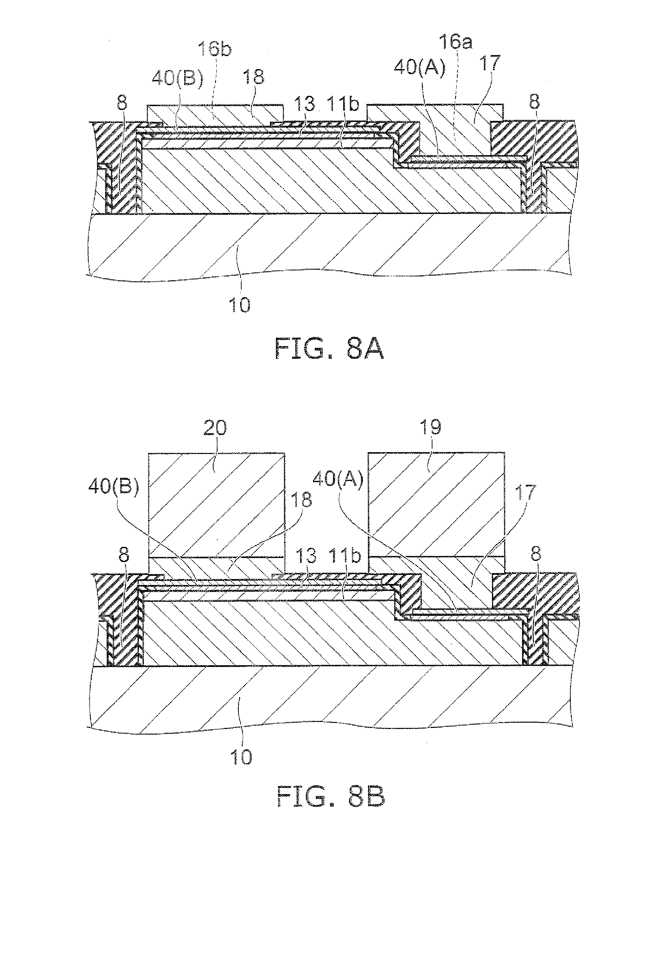

Consequently, as shown in FIG. 8A, a first interconnection 17 and a second interconnection 18 are selectively formed on the top surface of the second insulating film 16 (the surface on the opposite side to the first semiconductor layer 11 and the second semiconductor layer 12). The first interconnection 17 is also formed in the opening 16a, and is connected to the metal layer 40(A). The second interconnection 18 is also formed in the opening 16b, and is connected to the metal layer 40(B).

Subsequently, after the resist for plating that has been used in the plating of the first interconnection 17 and the second interconnection 18 is removed using a chemical solution, other resist for plating for forming metal pillars is formed, and a process of electrolytic plating is performed with the seed metal used mentioned above as a current pathway. Consequently, as shown in FIG. 8B, a first metal pillar 19 is formed on the first interconnection 17 whereas a second metal pillar 20 is formed on the second interconnection 18.

After that, the resist for forming metal pillars is removed using a chemical solution, and then exposed portions of the seed metal are removed. Consequently, the electric connection between the first interconnection 17 and the second interconnection 18 through the seed metal is cut off.

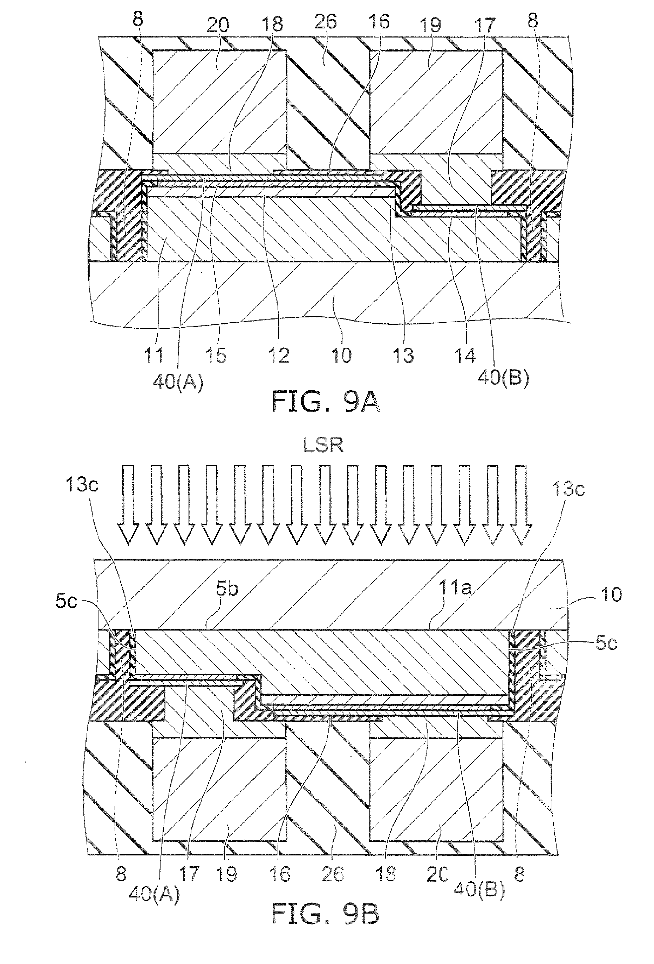

Subsequently, as shown in FIG. 9A, the first interconnection 17, the second interconnection 18, the first metal pillar 19, the second metal pillar 20, and the second insulating film 16 are covered with a resin (third insulating film) 26. The resin 26 reinforces the semiconductor layer 5, the first metal pillar 19, and the second metal pillar 20. The resin 26 is made, for example, of an epoxy resin, a silicone resin, or a fluorine resin. The resin 26 is colored in black, for example. The resin 26 thus prevents the light from leaking out and prevents unnecessary external light from entering.

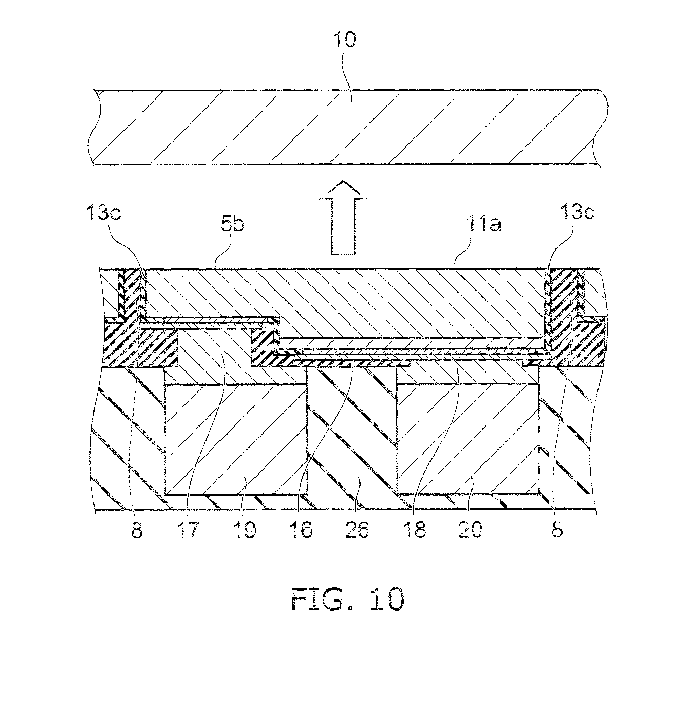

Subsequently, as shown in FIGS. 9B and 10, a process of laser lift off (LLO) is performed to remove the substrate 10 from the semiconductor layer 5. Each of the drawings in FIGS. 9B and 10 shows the structure shown in FIG. 9A upside down.

Laser light LSR to be used is light of ArF laser (wavelength: 193 nm); light of KrF laser (wavelength: 248 nm); light of XeCl laser (wavelength: 308 nm); or light of XeF laser (wavelength: 353 nm).

The laser light LSR is irradiated the semiconductor layer 5 from the second main surface 10b (the opposite side to the first main surface 10a) of the substrate 10 toward the semiconductor layer 5. The laser light LSR passes through the substrate 19, and reaches a lower surface (the second main surface 5c) of the semiconductor layer 5. The second insulating film 16 (irrespective of silicon nitride or a resin) and the semiconductor layer 5 absorb the laser light LSR. Alternatively, the band-gap energy of the second insulating film 16 and the band-gap energy of the semiconductor layer 5 are made smaller than the energy of the laser light LSR. Consequently, the laser light LSR that has passed through the substrate 10 is absorbed by the semiconductor layer 5 and the second insulating film 16. In the meanwhile, at the interface of the substrate 10 and semiconductor layer 5, the absorption of the laser light LSR causes the GaN component in the semiconductor layer 5 to be thermally decomposed in a manner shown in the following reaction formula.

$$GaN \rightarrow Ga + (1/2)\ N_2 \uparrow$$

Consequently, as shown in FIG. 10, the substrate 10 is removed from the semiconductor layer 5.

In this embodiment, the portion of the first insulating film 13 that is in contact with the substrate 10 is removed in advance (see FIG. 7A). Accordingly, when the substrate 10 is removed from the semiconductor layer 5 by the laser lift off, the first insulating film 13 does not adhere to the substrate 10, and the substrate 10 is removed easily. In particular, if the first insulating film 13 is thick, the adhering strength of the substrate 10 with this portion becomes strong. Therefore, if this portion of the first insulating film 13 is removed beforehand, the substrate 10 can be removed easily.

In addition, the band-gap energy of the first insulating film 13 is larger than the energy of the laser light LSR, Accordingly, the laser light LSR irradiated at the laser lit off enters the first insulating film 13c that cover the side surface (third main surface 5c) of the semiconductor layer 5, and then reaches the metal layer 40.

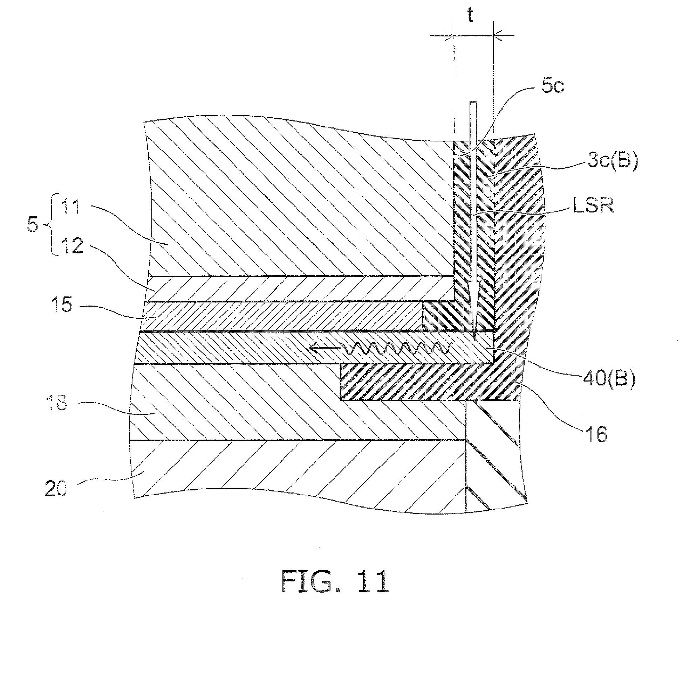

FIG. 11 is a schematic cross-sectional view illustrating a portion around the metal layer in an enlarged manner.

FIG 11 illustrates, in an enlarged manner, the portions of the first insulating film 13c and the metal layer 40(B) on the second electrode portion 15 side.

As has been described earlier, the band-gap energy of the first insulating film 13 is larger than the energy of the laser light LSR. In addition, the first insulating film 13c is formed so that its thickness t may be larger than the wavelength of the laser light LSR. Accordingly, the laser light LSR enters the end surfaces of lower surface (second main surface 5b) side of the first insulating film 13c covering the side surface 5c of the semiconductor layer 5. Then, the laser light LSR passes through the inside of the first insulating film 13c.

The laser light LSR that has passed through the first insulating film 13c is irradiated the metal layer 40(B) extending until reaching the extension, along the side surface (third main surface 5c), of the first insulating film 13c. The metal layer 40(B) is heated by the irradiation with the laser light LSR. The heat melts the metal layer 40(B), and heats both the first electrode portion 15 and the interface between the first electrode portion 15 and the second semiconductor layer 12. The heated first electrode portion 15 and the heated second semiconductor layer 12 are activated to reduce the bulk resistance of the second semiconductor layer 12 and the contact resistance between the second semiconductor layer 12 and the first electrode portion 15.

FIG. 11 illustrates portions 13c of the first insulating film 13c and the metal layer 40(B). Similar description can be made for portions of the first insulating film 13 and the metal layer 40(A).

A part of the first insulating film 13c(B) is in contact with the second semiconductor layer 12, the second electrode portion 15 and the metal layer 40(B). The edge of the first insulating film 13c(B) is interposed between the metal layer 40(B) and the second semiconductor layer 12 and in contact with the second electrode portion 15.

A part of the first insulating film 13c(A) is in contact with the first electrode portion 14 and the metal layer 40(A). The edge of 13c(A) is interposed between the metal layer 40(A) and the first semiconductor layer 11 and in contact with the first electrode portion 14.

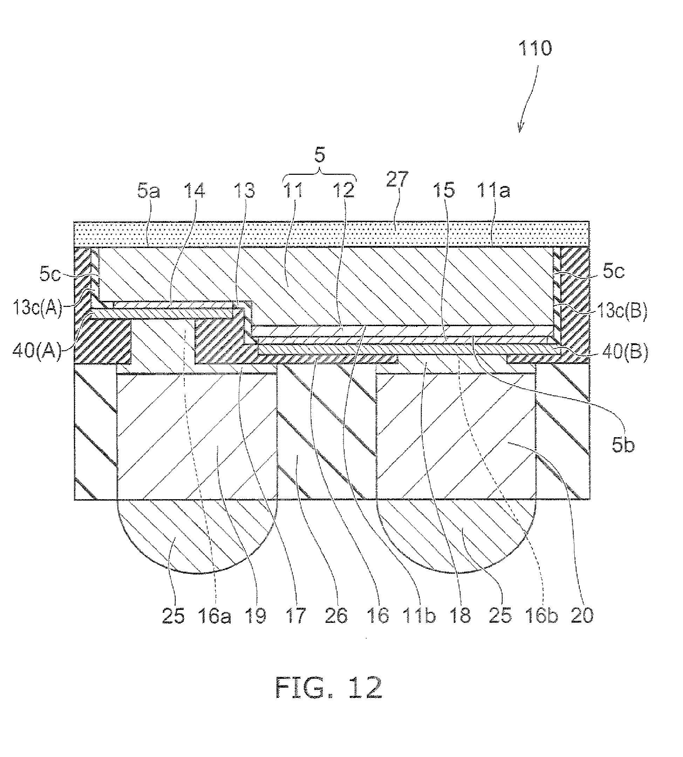

After that, as shown in FIG. 12, the surface of the resin 26 is ground until the end surfaces of the first metal pillar 19 and of the second metal pillar 20 are exposed. Then, if necessary, external terminals 25, such as solder balls or metal bumps, are provided on the exposed surfaces. Thus, a light-emitting device 110 is completed.

Since the use of this manufacturing method allows the light-emitting device 110 to be built at the wafer level, CSP (Chip Size Package) of the light-emitting device 110, whose size is as small as the size of the bare chip, can be provided easily. In addition, after building at the wafer level, the light-emitting devices 110 may be completed by dicing into individuals. The cutting method to be used is, for example, the mechanical machining using a diamond blade or the like, the cutting by laser irradiation, or the cutting by high-pressured water.

According to the method for manufacturing the iight-emitting device 110, the laser light irradiated at the laser lift off heats the metal layer 40 simultaneously with the laser lift off, so that the bulk resistance of the semiconductor layer 5 as well as the contact resistance between the semiconductor layer 5 and each of the first and the second electrode portions 14 and 15 can be reduced.

Third Embodiment

Subsequently, a light-emitting device according to a third embodiment will be described.

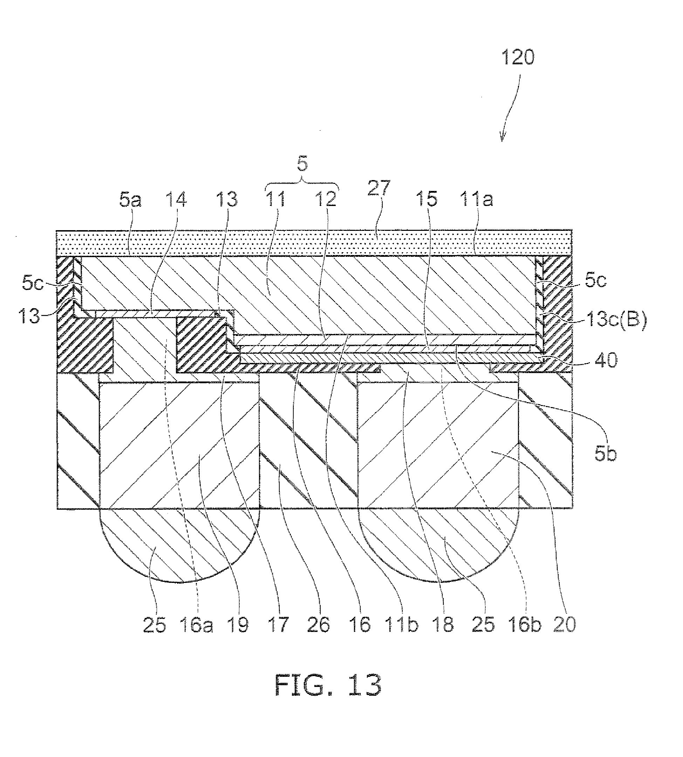

FIG. 13 is a schematic cross-sectional view illustrating the light-emitting device according to the third embodiment.

As shown in FIG. 13, in a light-emitting device 120 of the third embodiment, the metal layer 40 is provided so as to correspond only to the second electrode portion 15.

In other words, the metal layer 40 is stacked on the second electrode portion 15, and provided to extend until reaching the extension, along the third main surface 5c, of the first insulating film 13c(B) covering the third main surface 5c close to the second electrode portion 15. On the other hand, the first interconnection 17 is formed directly on the surface of the first electrode portion 14.

In the light-emitting device 120 like this, the laser light irradiated at the laser lift off passes through the first insulating film 13c that cover the third main surface 5c. The metal layer 40 is then irradiated with the laser light and is heated by the energy of the laser light. The heating of the metal layer 40 in turn heats the second electrode portion 15. In addition, the contact portion of the second semiconductor layer 12 with the second electrode portion 15 is heated. The heating reduces the bulk resistance of the second semiconductor layer 12 and the contact resistance between the second semiconductor layer 12 and the second electrode portion 15.

The second semiconductor layer 12 includes, for example, a p-type GaN layer. The p-type GaN layer is doped with Mg, for example. The heating of the metal layer 40 heats the second semiconductor layer 12, and activates the doped Mg. Accordingly, reduction in the bulk resistance of the second semiconductor layer 12 as well as reduction in the contact resistance between the second semiconductor layer 12 and the second electrode portion 15 can be accomplished.

According to the embodiments thus far described, in the light-emitting devices 110 and 120 employing the laser lift off, the irradiation with the laser light at the laser lift off heats the metal layer 40, and thus the bulk resistance of the semiconductor layer 5 as well as the contact resistance of the electrode portions that are electrically continuous to the semiconductor layer 5 can be reduced simultaneously with the laser lift off. Thus provided are the light-emitting devices 110 and 120 with high efficiency.

Hereinabove, some embodiments have been described with reference to specific examples. The above-described embodiments are not limited thereto. For example, from the aforementioned embodiments and variations, those skilled in the art may make different modes of embodiments by providing any additional constituent element or by omitting any constituent element, based on modified design, or by appropriately combining characteristic features in the above embodiments. These different modes of embodiments are also included in the scope of the invention as long as the modes retain the gist of the invention. In addition, those skilled in the art may make various kinds of changes in design concerning the substrate, the semiconductor layers, the electrodes, the interconnections, the metal pillars, the insulating films, the material of the resin, the size, the shape, the layout, and the like. Those thus changed are also included in the scope of the invention unless the changes depart from the gist of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

**Claims**

1.  A light-emitting device (110, 120) comprising:

    a semiconductor layer (5) including a first main surface (5a) , a second main surface (5b) on an opposite side to the first main surface (5a), a third main surface (5c) connecting the first main surface (5a) and the second main surface (5b), and a light-emitting layer (33);
    a first electrode portion 14 and a second electrode portion (15) provided on the second main surface (5b) of the semiconductor layer (5);
    a first insulating film (13) covering the second main surface (5b) of the semiconductor layer (5) and the third main surface (5c) of the semiconductor layer (5); and
    a metal layer (40, 40(A), 40(B)) stacked on at least the second electrode portion (15) of the first and the second electrode portions (14, 15), the metal layer (40, 40(A), 40(B)) extending until reaching a part of the first insulating film (13), the part being continuously extended from the first insulating film (13) which covers the third main surface (5c).

2.  The device (110, 120) according to claim 1, wherein the first insulating film (13) covering the third main surface (5c) has a thickness equal to or larger than a wavelength of laser light irradiated to remove a substrate (10) from the semiconductor layer (5) after the semiconductor layer (5) is formed on the substrate (10).

3.  The device (110, 120) according to any of claims 1 and 2, wherein the first insulating film (13) is made of a material with band-gap energy larger than energy of laser light irradiated to remove a substrate (10) from the semiconductor layer (5) after the semiconductor layer (5) is formed on the substrate (10).

4.  The device (110, 120) according to any of claims 1-3, further comprising a second insulating film (16) covering the first insulating film (13), wherein each of the second insulating film (16) and the semiconductor layer (5) is made of a material with band-gap energy smaller than energy of laser light irradiated to remove a substrate (10) from the semiconductor layer (5) after the semiconductor layer (5) is formed on the substrate (10).

5.  The device (110, 120) according to any of claims 1-4, further comprising a second insulating film (16) covering the first insulating film (13), wherein each of the second insulating film (16) and the semiconductor layer (5) is made of a material absorbing laser light irradiated to remove a substrate (10) from the semiconductor layer (5) after the semiconductor layer (5) is formed on the substrate (10).

6.  The device (110, 120) according to any of claims 1-5, wherein the metal layer (40, 40(A), 40(B)) includes at least one of aluminum and titanium.

7.  The device (110, 120) according to any of claims 1-6, wherein the metal layer (40, 40(A), 40(B)) is in contact with a surface of the second electrode portion (15).

8.  The device (110, 120) according to any of claims 1-7, wherein the metal layer (40, 40(A), 40(B)) is in contact with the part of the first insulating film (13) covering the third main surface (5c) close to the metal layer (40, 40(A), 40(B)).

9.  The device (110, 120) according to any of claims 1-8, further comprising:

    a second insulating film (16) covering the first insulating film (15);
    a first interconnection (17) piercing the second insulating film (16) and being electrically contact with the first electrode portion (14); and
    a second interconnection (18) piercing the second insulating film (16) and being electrically contact with the second electrode portion (15).

10. The device (110, 120) according to claim 9, further comprising:

    a third insulating film provided on the second insulating film (16);
    a first metal pillar (19) piercing the third insulating film and being electrically contact with the first interconnection (17); and
    a second metal pillar (20) piercing the third insulating film and being electrically contact with the second interconnection (18).

11. The device (110, 120) according to any of claims 1-10, wherein the first insulating film (13) has a thickness equal to or larger than 193 nanometers.

12. A method for manufacturing a light-emitting device, comprising:

    removing a substrate (10) from a semiconductor layer (5), the semiconductor layer (5) including a first main surface (5a), a second main surface (5b) on an opposite side to the first main surface (5b), a third main surface (5c) connecting the first main surface (5a) and the second main surface (5b, and a light-emitting layer (33), a first electrode portion (14) and a second electrode portion (15) being provided on the second main surface (5b) of the semiconductor layer (5), a first insulating film (13) covering the second main surface (5b) of the semiconductor layer (5) and the third main surface (5c) of the semiconductor layer (5) being provided, a metal layer (40, 40(A), 40(B)) stacked on at least the second electrode portion (15) of the first and the second electrode portions (14, 15) being provided, the metal layer (40, 40(A), 40(B)) extending until reaching a part of the first insulating film (13), the part being continuously extended from the first insulating film (13) which covers the third main surface (5c), the first main surface (5a) facing the substrate (10), the removing being performed by irradiating the semiconductor layer (5) with laser light through the substrate (10), the first insulating film (13) has band-gap energy larger than energy of the laser light.

13. The method according to claim 12, wherein the first insulating film (13) covering the third main surface (5c) has a thickness equal to or larger than a wavelength of the laser light.

14. The method according to any of claims 12 and 13, further comprising forming a second insulating film (16) covering the first insulating film (13), wherein each of the second insulating film (16) and the semiconductor layer (5) has band-gap energy smaller than the energy of the laser light.

15. The method according to any of claims 12-14, further comprising forming a second insulating film (16) covering the first insulating film, wherein the second insulating film (16) and the semiconductor layer (5) absorb the laser light.

16. The method according to any of claims 12-15, wherein the metal layer (40, 40(A), 40(B)) is formed to be in contact with a surface of the second electrode portion (15).

17. The method according to any of claims 12-16, wherein the metal layer (40, 40(A), 40(B)) is formed to be in contact with the part of the first insulating film (13).

18. The method according to any of claims 12-17, wherein a portion of the first insulating film (13) being in contact with the substrate (10) is removed after forming the first insulating film (13) and before irradiating with the laser light.

19. The method according to any of claims 12-18, further comprising:

forming a second insulating film (16) covering the first insulating film (13); and forming a first interconnection (17) piercing the second insulating film (16) and being electrically contact with the first electrode portion (14), and a second interconnection (18) piercing the second insulating film (16) and being electrically contact with the second electrode portion (15).

20. The method according to claim 19, further comprising:

forming a first metal pillar (19) electrically contact with the first interconnection (17) and a second metal pillar (20) electrically contact with the second interconnection (18); and forming a third insulating film around the first metal pillar (19) and the second metal pillar (20).

FIG. 1

| Mg | Al | Ti | Fe | Ni | Cu | Zn | Zr | Mo | Ag | W |
|------|------|------|------|------|------|------|------|------|------|------|
| 0.36 | 0.15 | 0.15 | 0.21 | 0.72 | 0.84 | 0.48 | 0.54 | 1.98 | 0.48 | 2.50 |

FIG. 2

FIG. 3

```
                    ┌─────────────┐
                    │    START    │
                    └──────┬──────┘
                           │
                           ▼
    ┌────────────────────────────────────────────┐
    │ FORM SEMICONDUCTOR LAYER ON SUBSTRATE │       S110
    └────────────────────┬───────────────────────┘
                           │
                           ▼
    ┌────────────────────────────────────────────┐
    │           FORM FIRST INSULATING FILM        │       S120
    └────────────────────┬───────────────────────┘
                           │
                           ▼
    ┌────────────────────────────────────────────┐
    │         FORM FIRST ELECTRODE PORTION AND    │       S130
    │            SECOND ELECTRODE PORTION         │
    └────────────────────┬───────────────────────┘
                           │
                           ▼
    ┌────────────────────────────────────────────┐
    │              FORM METAL LAYER               │       S140
    └────────────────────┬───────────────────────┘
                           │
                           ▼
    ┌────────────────────────────────────────────┐
    │         FORM SECOND INSULATING FILM         │       S150
    └────────────────────┬───────────────────────┘
                           │
                           ▼
    ┌────────────────────────────────────────────┐
    │              REMOVE SUBSTRATE               │       S160
    └────────────────────┬───────────────────────┘
                           │
                           ▼
                    ┌─────────────┐
                    │     END     │
                    └─────────────┘
```

FIG. 4

FIG. 5

FIG. 6A

FIG. 6B

FIG. 6C

FIG. 7A

FIG. 7B

FIG. 7C

FIG. 8A

FIG. 8B

FIG. 9A

FIG. 9B

10

13c  5b  11a  13c

FIG. 10

8  17  19  16  26  18  20  8

FIG. 11

110

FIG. 12

120

5

5a   14   13   11   12   27   15   11a

5c

13

13c(B)

40

5b

25  16a  19  17  26  16  11b  18  25  16b  20

FIG. 13